# EUROPÄISCHE PATENTSCHRIFT

(11) **EP 0 288 807 B1**
(45) Veröffentlichungstag und Bekanntmachung des Hinweises auf die Patenterteilung: **25.01.1995**
(21) Anmeldenummer: 88105658.4
(22) Anmeldetag: 08.04.1988
(51) Int. Cl.: C08J 3/28, C08F 38/00, C08F 8/00, H01B 1/12

(54) **Leitfähige Strukturen in Polymeren**
Conductive structures in polymers
Structures conductibles aux polymères

(30) Priorität: 09.04.1987 DD 301649
(43) Veröffentlichungstag der Anmeldung: 02.11.1988
(73) Patentinhaber: Roth, Hans-Klaus, Prof. Dr., 04209 Leipzig (DE)
(72) Erfinder: Gruber, Harald, Dr., DDR-8020 Dresden (DD); Richter, Andreas M., Dr., DDR-4090 Halle-Neustadt (DD); Fanghänel, Egon, Prof. Dr., DDR-4020 Halle (DD); Roth, Hans-Klaus, Prof. Dr., DDR-7060 Leipzig (DD); Friedrich, Heinz, DDR-7050 Leipzig (DD); Maras, Siegfried, Dr., DDR-7025 Leipzig (DD)
(74) Vertreter: Radwer, Dieter

(56) Entgegenhaltungen:
- EP-A- 0 009 245
- EP-A- 0 022 271
- DD-A- 235 654
- DD-A- 238 614

## Beschreibung

Die Erfindung betrifft leitfähige Strukturen in Polymeren, die in der Elektrotechnik, Elektronik und Mikroelektronik angewendet werden können.

Der Einsatz von Polymeren in der Elektrotechnik, Elektronik und Mikroelektronik zu Isolierzwecken ist hinreichend bekannt. Dabei wird allgemein das Ziel verfolgt, einerseits die bekannten günstigen Eigenschaften von Polymeren gegenüber Metallen, wie frei wählbare Formgebung, Flexibilität, geringes Gewicht, leichte Verarbeitbarkeit und praktisch unbegrenzte chemische Modifizierbarkeit und unter Beibehalt dieser positiven Eigenschaften andererseits, sie gleichzeitig als elektrisch leitfähige Werkstoffe zu nutzen. Zur Herstellung leitfähiger polymerer Materialien werden unterschiedliche Verfahren angewandt (z. B. R. Seymour Conductive Polymers, Plenum Press, New York 1981 und H. Kuzmany, Elektronic properties of polymers and related compounds, Springer Verlag, Berlin, Heidelberg, New York 1985).

Die bekannten Lösungen zur Erzeugung leitfähiger Schichten, z. B. durch Einbringen niedermolekularer Charge-Transfer(CT)-Komplexe in Polymermatrizen (Europatente 0147 871 A2 und 0134 026 A1, US- Patent 4478 922), das Behandeln mit geeigneten Oxydations- und Reduktionsmitteln (s. R. Seymour, Conductive Polymers) oder das Zumischen von Ruß (T. Slupkowski, Phys. stat. sol. (a) 90 (1985) 737 - 741) eigen sich nicht für gezielte Strukturierungen im µm-Bereich, wie sie z. B. für Leiterbahnen in der Mikroelektronik benötigt werden, oder sie zeigen nicht die für eine Anwendung geforderte Beständigkeit gegen Umwelteinflüsse.

Die bisher bekannten Verfahren zur Erzielung elektrisch leitfähiger Strukturen in Polymeren, sind technisch sehr aufwendig zu realisieren, wobei die Endprodukte gleichfalls ein ungünstiges Umgebungsverhalten aufweisen.

So wird in der DE-OS 2627 828 ein Verfahren beschrieben, bei welchem man eine Lösung mit einem Gehalt an einer organischen π-Elektronen-Donorverbindung und einem Halogenkohlenwasserstoff auf ein Substrat aufträgt, danach mit aktinischer Strahlung in einem vorbestimmten Muster belichtet und dann das überschüssige Lösungsmittel und/oder den Halogenkohlenwasserstoff verdampft. Die Verbindungen, die in der DE-OS 2627 828 verwendet werden, sind vom (Donor)Xₙ-Typ, wobei der Donor vorrangig aus der Gruppe von Tetrathiafulvalen, Tetraselenafulvalen, cis/trans-Diselenadithiafulvalen stammt und X aus der Gruppe von F, Br, Cl und I gewählt ist (n < 1).

Bei Anwendung der Schichtkombination im technisch relevanten sichtbaren spaktralen Anregungsbereich werden zusätzlich Farbstoffe verwendet. Der Nachteil dieses Vielkomponentensystems besteht vorrangig im komplizierten Schichtaufbau und damit in einer aufwendigen Schichtherstellung. Weiterhin zeigen viele CT-Komplexe eine Abnahme der elektrischen Leitfähigkeit mit der Lagerdauer, so daß die Schichten zusätzlich stabilisiert werden müssen (z. B. durch Deckschichten). Diese Deckschichten sind technisch meist sehr aufwendig zu realisieren, z. B. durch Glimmpolymerisation bzw. erfordern spezielle Polymere (z. B. J. E. Osterholm u. a., J. of Appl. Polymer Sci. 27 (1982) 931 - 936).
Für eine Anwendung der Schichten für Leiterplatten wirken sich diese notwendigen Maßnahmen sehr ungünstig aus (beispielsweise Kontaktierung).

Bekannte Lösungen zur Herstellung von Leiterbahnen, Schaltkontakten und Kontakten, bei welchen Metall teilweise bzw. vollständig substituiert wird, beruhen auf der Anwendung von Massen mit metallisch leitfähigen Bestandteilen, wie Silberteilchen (US-PS 4289 534), Goldteilchen (US-PS 4230 493) oder auf der Verwendung von Zusätzen wie Leitfähigkeitsruß, Graphit, Eisenoxid, Kupfer- oder Aluminiumteilchen usw. (z. B. M. J. Mair Gummi, Faser, Kunststoffe 38 (1985) 3, 122 - 124).
So wird in der Patentschrift DD 221 868 A1 ein Verfahren offenbart, bei dem zur Herstellung von Leiterbahnen Massen verwendet werden, deren leitfähige Komponente aus Ruß- oder Graphitteilchen besteht. Der mit noch weiteren Zusätzen versehene Lack wird z. B. auf Leiterschablonen aufgespritzt, wobei Leiterbahnen mit einem spezifischen Widerstand von 2 . 10⁴ Ω mm²/m (60 Gew. % Graphit) entstehen. Nachteilig ist auch bei diesen Verfahren, daß eine gezielte u. a. rechnergestützte Mikrostrukturierung, welche eine Fertigung unterschiedlicher Leiterplattenelemente (Leiterbahnen, aktive und passive Systemkomponenten) in kürzester Zeit und auf geringstem Raum zuläßt, nicht möglich ist.
Weitere Verfahren bestehen in der Herstellung elektrisch leitender Materialien durch Pyrolyse (Pyrokonversion) von Polymeren (z. B. J. Simitzis Makromol. Chem. 185 (1984) 2569 -2581). Der thermische Abbau von Polymeren führt zu Materialien, die Kohlenstoff in verschiedenen Modifikationen enthalten und sehr gut temperatur- und chemikalienbeständig sind. Ein wesentlicher Nachteil besteht bei den bisher synthetisierten Polymeren zum einen darin, daß sie keine gute Filmbildung aufweisen und zum anderen, daß die Pyrolysetemperaturen zur Erzeugung der benötigten Leitfähigkeiten sehr hoch sind, z. B. 700 °C bei Polyphenylenen. Die bei diesen Temperaturen erzeugten Pyrolyseprodukte weisen meist keinen Zusammenhalt mehr auf (J. Simitzis, Makromol. Chem. 185 (1984) 2569 - 2581). Ein weiterer Nachteil ist, daß die Pyrolyse vorwiegend unter inerten Bedingungen ablaufen muß, wodurch sich der technische Aufwand erheblich erhöht.

Der Erfindung liegt die Aufgabe zugrunde, zusammenhängende leitfähige Strukturen in Polymeren durch Einwirkung von Strahlung hoher Energiedichte bei verhältnismäßig geringen Temperaturen in wenigen Arbeitsschritten auszubilden.

Erfindungsgemäß wird die Aufgabe dadurch gelöst, daß für die strahlungsinduzierte Pyrokonversion Poly(organylheteroacetylene) der Formel I verwendet werden: 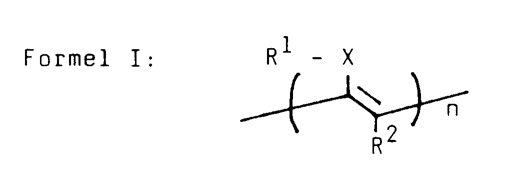
wobei X Schwefel oder Selen; R¹ und R² Alkyl mit 1 bis 12 C-Atomen, vorzugsweise mit 1 bis 7 C-Atomen, vorzugsweise Methyl, Ethyl, n-Propyl, i-Propyl, t-Butyl; R¹ und R² Cycloalkyl mit 3 bis 10 C-Atomen, vorzugsweise mit 5 bis 7 C-Atomen, vorzugsweise Cyclopentyl, Cyclohexyl; R¹ und R² Aralkyl mit 7 bis 15 C-Atomen, vorzugsweise mit 7 bis 11 C-Atomen, vorzugsweise Benzyl, Phenyl-ethyl; R¹ und R² Aryl mit 6 bis 18 C-Atomen, vorzugsweise mit 6 bis 12 C-Atomen, vorzugsweise Phenyl, Naphthyl; R¹ und R² Heterocyclyl mit 2 bis 10 C-Atomen und 1 bis 4 gleichen oder unterschiedlichen Heteroatomen wie Stickstoff, Sauerstoff, Schwefel, vorzugsweise mit 4 bis 7 C-Atomen und 1 bis 2 gleichen oder unterschiedlichen Heteroatomen, vorzugsweise Sauerstoff und Schwefel, vorzugsweise Tetrahydrofuryl, Tetrahydrothiophenyl, Tetrahydropyranyl, Thienyl, Furyl, Pyridyl sein kann; wobei R² außerdem Wasserstoff oder eine Gruppe R³-Y sein kann, wobei Y Schwefel oder Selen sein kann; X und Y identisch sein können, wobei R³ die für R¹ angegebene Bedeutung haben kann; wobei R¹ und R² bzw. R¹ und R³ identisch sein können; wobei R¹ und/oder R² bzw. R³ durch Gruppen wie Alkoxy, Aralkoxy, Aryloxy, Heterocyclyloxy, Alkylthio, Aralkylthio, Arylthio, Heterocyclylthio, Alkylseleno, Aralkylseleno, Arylseleno, Heterocyclylseleno, wobei die diesen Gruppen zugrunde liegenden Alkyl-, Aralkyl-, Aryl- bzw. Heterocyclylreste die für R¹ angegebene Bedeutung haben, Cyano, Halogen, wie Fluor, Chlor, Brom oder Iod, vorzugsweise Chlor oder Brom, Nitro, Carbonylsubstituenten mit 1 bis 15 C-Atomen, vorzugsweise mit 1 bis 5 C-Atomen, vorzugsweise Formyl, Acetyl, Chlorcarbonyl, Alkoxycarbonyl, wobei die dem Alkoxyrest zugrunde liegenden Alkylgruppen die für R¹ angegebene Bedeutung haben, Aminocarbonyl, Carboxylat oder Ammonium-, Sulfonium-, Phosphoniumgruppen, vorzugsweise Trialkylammonium, Dialkylsulfonium, Trialkylphosphonium, wobei die Alkylreste die für R¹ angegebene Bedeutung haben, substituiert sein können; wobei die Gruppen R¹ und/oder R² unterschiedlicher Monomereinheiten miteinander direkt oder durch Gruppen, vorzugsweise Methylen, Benzyliden, Phenylen verknüpft sein können, wobei die Substituenten R¹-X und/oder R² unterschiedlicher Monomereinheiten identisch sein können; wobei n Werte von 2 und höher, vorzugsweise zwischen 3 und 200 annehmen kann. Die Poly(organylheteroacetylene) sind in einfacher Weise durch komplexkatalysierte Polymerisation der entsprechenden Organylheteroacetylene darstellbar (Literatur: DD WP 211 118, DD WP 235 654, DD WP 238 614, Richter, A. M. u. a. Journal für praktische Chemie 329 (1987) 811). Die Reste R¹ und R² sind dabei in weiten Bereichen variierbar.
Die dargestellten Poly(organylheteroacetylene) sind leicht in gebräuchlichen Lösungsmitteln wie Chloroform und Tetrahydrofuran löslich und weisen eine sehr gute Filmbildung auf.
Durch die Wahl der entsprechenden Substituenten und Herstellungsbedingungen der Polymeren ist gleichzeitig eine Sensibilisierung für die einzusetzende Bestrahlungswellenlänge möglich. Bei Anwendung von Polymerisationstemperaturen oberhalb von 25 °C gelingt es, die Absorption der Poly(organylheteroacetylene) nach längeren Wellenlängen zu verschieben. Diese Verschiebung wird ebenfalls durch Verwendung spezieller Katalysatoren, vorzugsweise Bis-Triorganylphosphin-Ni(II)iodid unterstützt. Die Farbe der Polymere ändert sich dabei von grau-braun nach braun-rot. Erfindungsgemäß werden die obengenannten Polymeren in einem handelsüblichen Lösungsmittel gelöst und unter Anwendung bekannter Beschichtungsverfahren auf starre oder flexible Trägermaterialien aufgebracht. Die Aushärtung der Schichten erfolgt durch Verdampfen des Lösungsmittels. Nachfolgend wird die Schichtkombination so mit Strahlung hoher Energiedichte, vorzugsweise Laserstrahlung, beaufschlagt, daß elektrisch leitfähige Strukturen entstehen. Zu diesem Zweck wird die Strahlung durch geeignete Methoden abgelenkt, moduliert und gegebenenfalls in die Bearbeitungsebene fokussiert. Dieser Prozeß erfolgt vorzugsweise rechnergestützt, wobei zur Aufzeichnung der gewünschten Strukturen gleichzeitig eine Ablenkung der Strahlung und/oder eine Bewegung der Schichtkombination erfolgt. Die Bestrahlung kann dabei in Sauerstoffatmosphäre unter Normalbedingungen erfolgen. Die Auswahl der einzusetzenden Energiequellen, z. B. des Lasers, richtet sich nach der geforderten Mikrostrukturierung, wobei die Bestrahlung so zu wählen ist, daß die benötigte Temperatur erreicht wird. Bei Temperaturen von 100 °C bis 600 °C, vorzugsweise 150 °C bis 300 °C, werden bei den erwähnten Poly(organylheteroacetylenen) schwefel- bzw. selenhaltige kohlenstoffreiche Pyrolysate mit hoher elektrischer Leitfähigkeit in einem Arbeitsschritt gebildet. Eine Entfernung der unbestrahlten Bereiche braucht nicht zu erfolgen. Die hergestellten elektrisch leitfähigen Bereiche sind gegen Umwelteinflüsse, z. B. Luftfeuchtigkeit, stabil.
Zum Schutz der leitfähigen Strukturen und zur erhöhten Isolierung kann nachträglich auf der Leiterplatte eine Deckschicht aufgebracht werden oder durch eine vorher aufgebrachte Deckschicht bestrahlt werden.
Erfindungsgemäß können auch die Poly(organylheteroacetylene) mit anderen Polymeren gemischt werden. Für Anwendungsfälle, die eine spezielle Polymerart erfordern, ist es möglich, die Poly(organylheteroacetylene) in das Matrixpolymer einzuarbeiten bzw. bei gleichen Lösungsmitteln von Matrixpolymeren und Poly(organylheteroacetylenen) Schichten herzustellen. Geeignete Polymere sind u. a. Polystyren und Polyvinylchlorid. Die Auswahl der Polymere richtet sich nach dem Anwendungszweck. Soll z. B. eine Strukturierung durch Fokussierung der Strahlung in tieferen Schichtbereichen vorgenommen werden, sind für die aktive Strahlung transparente Polymere, z. B. für den sichtbaren Spektralbereich Polystyren, auszuwählen. Dadurch ist es möglich, das Absorptionsverhalten eines Materials einer Strahlungsquelle anzupassen, und es kann eine hohe Effektivität in der Ausnutzung der eingesetzten Strahlung erreicht werden.
Durch Zusatz von Metallverbindungen der Elemente der 8. Nebengruppe, vorzugsweise deren Salze oder Phosphin-, Phosphit-, Carbonylkomplexe, ist es möglich, die Empfindlichkeit der Schichten für die angewendete Strahlung zu erhöhen.
Die durch die Erfindung erreichten Vorteile sind im wesentlichen darin zu sehen, daß die leitfähigen Strukturen, vorrangig aber Leiterbahnen, in einem Arbeitsschritt in eine isolierende Polymermatrix mit Hilfe von Strahlung hoher Energiedichte eingeschrieben werden.

Gegenüber den bislang bekannten aufwendigen Verfahren zur Erzeugung von Leiterstrukturen, vorzugsweise für Leiterplatten, sind nur wenige Arbeitsschritte notwendig, wodurch Zeit und Material eingespart werden, und es entfallen die durch die bisher notwendigen vielen Arbeitsschritte auftretenden Übertragungsfehler.

Die Erfindung ermöglicht es auch, die moderne Computertechnik (Computergrafik) einzusetzen, gewährleistet eine rechnergestützte Direktherstellung von Leiterstrukturen und wird auch dem Trend nach Miniaturisierung des Leiterbildes gerecht. Durch den Einsatz spezieller filmbildender polymerer Materialien, die eine Umwandlung zu elektrisch leitfähigen Strukturen bei vergleichsweise geringen Temperaturen unter Ausschluß der im Stand der Technik aufgezeigten Mängel möglich machen und durch Strukturierung dieser Materialien in einem Arbeitsschritt entstehen langzeitstabile leitfähige Bereiche im signifikanten µm-Bereich, wobei eine gleichzeitige Isolierung dieser leitfähigen Bahnen durch die Polymermatrix erfolgt. Dabei bestehen die leitfähigen Bereiche aus zusammenhängenden Strukturen, die somit den, vorzugsweise für eine Leiterbahn, benötigten Zusammenhalt aufweisen.

Durch die überraschend niedrigen Pyrolysetemperaturen sind eine hohe Energieeinsparung und hohe Aufzeichnungsgeschwindigkeiten bei sehr guter Auflösung möglich. Weiterhin werden die verwendeten Trägermaterialien, vorzugsweise die flexiblen Materialien, durch die benötigten geringen Pyrolysetemperaturen wenig belastet.

Die Erfindung soll nachstehend an mehreren Ausführungsbeispielen näher erläutert werden:

### 1. Beispiel

5 Gew.-% Poly(bismethylthioacetylen), mittleres Molekulargewicht M̅ₙ = 3770, wird in Chloroform gelöst und auf Polyethylenfolien aufgeschleudert, so daß 10 µm dicke Schichten entstehen.
Die so hergestellten Folien werden mittels Argonionenlaser (Wellenlänge 488 nm, Strahlungsfluß 1,4 W) und Nachfolgeoptik streifenweise belichtet. Die Scangeschwindigkeit beträgt 5 ms⁻¹. Die belichteten Streifen weisen eine elektrische Leitfähigkeit von 10² Scm⁻¹ auf. Bei der Bestrahlung traten Temperaturen von ca. 280 °C auf.

### 2. Beispiel

5 Gew.-% Poly(bispropylthioacetylen), M̅ₙ = 3410, wird in Methylenchlorid unter Zusatz von 10⁻² Gew.-% Tetrakis(triphenylphosphito)nickel(O) gelöst und auf Polyimidfolien aufgeschleudert, so daß 10 µm dicke Schichten entstehen.
Die so hergestellten Folien werden wie im Beispiel 1 belichtet. Die Scangeschwindigkeit beträgt 8 ms⁻¹. Die belichteten Streifen weisen eine elektrische Leitfähigkeit von 5 . 10² Scm⁻¹ auf. Bei der Bestrahlung traten Temperaturen im Bereich von 270 °C bis 320 °C auf.

### 3. Beispiel

7,5 Gew.-% Poly(bis-n-butylthioacetylen), M̅ₙ = 4450, wird in Chloroform gelöst und auf Polyimidfolien aufgeschleudert, so daß 10 µm dicke Schichten entstehen.
Die so hergestellten Folien werden wie im Beispiel 1 belichtet. Die Scangeschwindigkeit beträgt 8 ms⁻¹. Es treten Temperaturen von ca. 250 °C bis 280 °C auf.
Die belichteten Bahnen weisen eine elektrische Leitfähigkeit von 2.10² Scm⁻¹ auf. Zwischen zwei im Abstand von 2 mm befindlichen parallelen Leiterbahnen der Länge 50 mm wurde ein Widerstand des unbestrahlten Materials größer 10¹⁴ Ω gemessen.

### 4 Beispiel

10 Gew.-% Polystyren und 90 Gew.-% Poly(bisethylthioacetylen), M̅ₙ = 1260, werden in Chloroform gelöst und auf Polyimidfolien aufgeschleudert, so daß 10 µm dicke Schichten entstehen.
Dieses Gemisch aus Polymeren wird wie im Beispiel 1 belichtet. Die gewählte Scangeschwindigkeit beträgt 6 ms⁻¹, wobei Temperaturen um 250 °C kurzzeitig auftraten.
Die belichteten Bahnen weisen eine elektrische Leitfähigkeit von 2 . 10² Scm⁻¹ auf.

### 5. Beispiel

7,5 Gew.-% Poly(bisethylthioacetylen), M̅ₙ = 1260, wird in Toluol unter Zusatz von 3 Gew.-% Trinitrofluorenon (bezogen auf die Polymereinwaage) gelöst und auf Polyimidfolien aufgebracht, so daß 10 µm dicke Schichten entstehen. Die hergestellten Folien werden wie im Beispiel 1 belichtet, wobei die Scangeschwindigkeit 8 ms⁻¹ beträgt. Die bei der Bestrahlung entstehenden Temperaturen liegen bei ca. 260 °C.
Die belichteten Streifen weisen eine elektrische Leitfähigkeit von 10² Scm⁻¹ auf.

### 6. Beispiel

5 Gew.-% Poly(cyclohexylthioacetylen), M̅ₙ = 1830, wird in Tetrahydrofuran unter Zusatz von 1 Gew.-% Bis-Triphenylphosphin-Ni(II)-bromid (bezogen auf die Polymereinwaage) gelöst und auf Polyimidfolien aufgeschleudert, so daß 10 µm dicke Schichten entstehen. Die so hergestellten Folien werden wie im Beispiel 1 belichtet. Die Scangeschwindigkeit beträgt 8 ms⁻¹. Dabei treten Temperaturen von ca. 280 °C auf.
Die belichteten Streifen weisen eine elektrische Leitfähigkeit von 2 . 10² Scm⁻¹ auf.

### 7. Beispiel

10 Gew.-% Poly(bisbenzylthioacetylen), M̅ₙ = 860, wird in Chloroform gelöst und auf Polyimidfolien aufgeschleudert, so daß 10 µm dicke Schichten entstehen. Die so hergestellten Folien werden wie im Beispiel 1 belichtet. Die Scangeschwindigkeit beträgt 1 ms⁻¹. Es treten Temperaturen von ca. 550 °C auf. Die belichteten Streifen weisen eine Leitfähigkeit von 10 Scm⁻¹ auf.

### 8. Beispiel

Auf die im Beispiel 1 hergestellten Folien wird zusätzlich eine Deckfolie aus Polyvinylacetat aufgebracht, durch welche im gleichen Aufzeichnungsregime belichtet wird. Unter den Bestrahlungsbedingungen des Beispiels 1 ergeben sich Leitfähigkeiten von 10² Scm⁻¹.

### 9. Beispiel

10 Gew.-% Poly(bisehylthioacetylen), M̅ₙ = 1260, wird in Tetrahydrofuran unter Zusatz von 10 Gew.-% Polystyren und 1 Gew.-% Tetrakis(triphenylphosphito)nickel(0) (beides bezogen auf die Polymereinwaage) gelöst und auf Polyimidfolien aufgeschleudert, so daß 10 µm dicke Schichten entstehen. Die so hergestellten Folien werden wie im Beispiel 1 belichtet. Die Scangeschwindigkeit beträgt 5 ms⁻¹. Bei der Bestrahlung treten Temperaturen von ca. 250 °C auf. Die belichteten Streifen weisen eine elektrische Leitfähigkeit von 1 Scm⁻¹ auf.

### 10 Beispiel

10 Gew.-% Poly(bisethylselenoacetylen), M̅ₙ = 1400, wird in Chloroform gelöst und auf Polyimidfolien aufgeschleudert, so daß 12 µm dicke Schichten entstehen. Die so hergestellten Schichten werden wie im Beispiel 1 belichtet. Die Scangeschwindigkeit beträgt 4 ms⁻¹. Es treten Temperaturen von ca. 150 °C auf. Die belichteten Streifen weisen eine elektrische Leitfähigkeit von 10⁻³ Scm⁻¹auf.

## Patentansprüche

1. Leitfähige Strukturen in Polymeren, erhältlich durch ein Verfahren, bei dem Poly(organylheteroacetylene) der 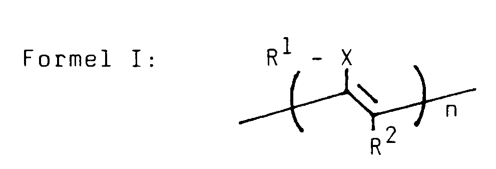 wobei X Schwefel oder Selen; R¹ und R² Alkyl mit 1 bis 12 C-Atomen, vorzugsweise mit 1 bis 7 C-Atomen, vorzugsweise Methyl, Ethyl, n-Propyl, i-Propyl, t-Butyl; R¹ und R² Cycloalkyl mit 3 bis 10 C-Atomen, vorzugsweise mit 5 bis 7 C-Atomen, vorzugsweise Cyclopentyl, Cyclohexyl; R¹ und R² Aralkyl mit 7 bis 15 C-Atomen, vorzugsweise mit 7 bis 11 C-Atomen, vorzugsweise Benzyl, Phenyl-ethyl; R¹ und R² Aryl mit 6 bis 18 C-Atomen, vorzugsweise mit 6 bis 12 C-Atomen, vorzugsweise Phenyl, Naphthyl; R¹ und R² Heterocyclyl mit 2 bis 10 C-Atomen und 1 bis 4 gleichen oder unterschiedlichen Heteroatomen wie Stickstoff, Sauerstoff, Schwefel, vorzugsweise mit 4 bis 7 C-Atomen und 1 bis 2 gleichen oder unterschiedlichen Heteroatomen, vorzugsweise Sauerstoff und Schwefel, vorzugsweise Tetrahydrofuryl, Tetrahydrothiophenyl, Tetrahydropyranyl, Thienyl, Furyl, Pyridyl sein kann; wobei R² außerdem Wasserstoff oder eine Gruppe R³-Y sein kann, wobei Y Schwefel oder Selen sein kann; X und Y identisch sein können, wobei R³ die für R¹ angegebene Bedeutung haben kann; wobei R¹ und R² bzw. R¹ und R³ identisch sein können; wobei R¹ und/oder R² bzw. R³ durch Gruppen wie Alkoxy, Aralkoxy, Aryloxy, Heterocyclyloxy, Alkylthio, Aralkylthio, Arylthio, Heterocyclylthio, Alkylseleno, Aralkylseleno, Arylseleno, Heterocyclylseleno, wobei die diesen Gruppen zugrunde liegenden Alkyl-,Aralkyl-, Aryl- bzw. Heterocyclylreste die für R¹ angegebene Bedeutung haben, Cyano, Halogen, wie Fluor, Chlor, Brom oder Iod, vorzugsweise Chlor oder Brom, Nitro, Carbonylsubstituenten mit 1 bis 15 C-Atomen, vorzugsweise mit 1 bis 5 C-Atomen, vorzugsweise Formyl, Acetyl, Chlorcarbonyl, Alkoxycarbonyl, wobei die dem Alkoxyrest zugrunde liegenden Alkylgruppen die für R¹ angegebene Bedeutung haben, Aminocarbonyl, Carboxylat oder Ammonium-, Sulfonium-, Phosphoniumgruppen, vorzugsweise Trialkylammonium, Dialkylsulfonium, Trialkylphosphonium, wobei die Alkylreste die für R¹ angegebene Bedeutung haben, substituiert sein können; wobei die Gruppen R¹ und/oder R² unterschiedlicher Monomereinheiten miteinander direkt oder durch Gruppen, vorzugsweise Methylen, Benzyliden, Phenylen verknüpft sein können, wobei die Substituenten R¹-X und/oder R² unterschiedlicher Monomereinheiten identisch sein können; wobei n Werte von 2 und höher, vorzugsweise zwischen 3 und 200 annehmen kann; oder ein Gemisch aus Poly(organylheteroacetylenen) der Formel I und anderen Polymeren, wobei der Masseanteil der zugesetzten Polymeren bis 30 % betragen kann, einer Strahlung hoher Energiedichte zur strahlungsinduzierten Modifizierung und damit zur Erhöhung der elektrischen Leitfähigkeit ausgesetzt werden, wobei Temperaturen von 100 °C bis 600 °C zur Anwendung kommen und die Polymere freitragend verwendet oder auf starre oder flexible Materialien aufgebracht werden.

2. Strukturen nach Anspruch 1, dadurch gekennzeichnet, daß als Strahlung hoher Energiedichte Laserstrahlung verwendet wird.

3. Strukturen nach Anspruch 1, dadurch gekennzeichnet, daß Temperaturen von 150 °C bis 300 °C zur Anwendung kommen.

4. Strukturen nach Anspruch 1, dadurch gekennzeichnet, daß Metallverbindungen der Elemente der 8. Nebengruppe, vorzugsweise Nickel, Cobalt, Eisen, wie deren Salze oder Komplexe, vorzugsweise Phosphin-, Phosphit- und Carbonylkomplexe, zugesetzt werden, wobei der Anteil der Metallverbindungen, bezogen auf die Polymereinwaage bis 5 %, vorzugsweise von 0,5 bis 3 %, betragen kann.

5. Strukturen nach Anspruch 1, dadurch gekennzeichnet, daß daß die Polymere, je nach Verwendungszweck, so ausgewählt werden, daß sie für die entsprechende Wellenlänge der Strahlung empfindlich sind.

6. Strukturen nach Anspruch 1, dadurch gekennzeichnet, daß nachträglich eine Deckschicht aufgebracht wird oder die Polymere durch eine vorher aufgebrachte Deckschicht bestrahlt werden.

## Claims

1. Conductive structures in polymer, obtained by a process in which poly(organylheteroacetylenes) of 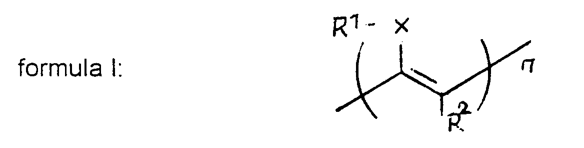 in which X can be sulphur or selenium; R¹ and R² alkyl with 1 to 12 C atoms, preferably with 1 to 7 C atoms, preferably methyl, ethyl, n-propyl, i-propyl, t-butyl; R¹ and R² cycloalkyl with 3 to 10 C atoms, preferably with 5 to 7 C atoms, preferably cyclopentyl, cyclohexyl; R¹ and R² aralkyl with 7 to 15 C atoms, preferably with 7 to 11 C atoms, preferably benzyl, phenyl-ethyl; R¹ and R² aryl with 6 to 18 C atoms, preferably with 6 to 12 C atoms, preferably phenyl, naphthyl; R¹ and R² heterocyclyl with 2 to 10 C atoms and 1 to 4 identical or different heteroatoms such as nitrogen, oxygen, sulphur, preferably with 4 to 7 C atoms and 1 to 2 identical or different heteroatoms, preferably oxygen and sulphur, preferably tetrahydrofuryl, tetrahydrothiophenyl, tetrahydropyranyl, thienyl, fury, pyridyl; in which R² can also be hydrogen or a group R³-Y, in which Y can be sulphur or selenium; X and Y can be identical, in which R³ can have the meaning given for R¹; in which R¹ and R² or R¹ and R³ can be identical; in which R¹ and/or R², or R³, can be substituted by groups such as alkoxy, aralkoxy, aryloxy, heterocyclyloxy, alkylthio, aralkylthio, arylthio, heterocyclylthio, alkylseleno, aralkylseleno, arylseleno, heterocyclylseleno, in which the alkyl, araylkyl, aryl or heterocyclyl residue on which these groups are based have the meaning given for R¹, cyano, halogen, such as fluorine, chlorine, bromine or iodine, preferably chlorine or bromine, nitro, carbonyl substitutes with 1 to 15 C atoms, preferably with 1 to 5 C atoms, preferably formyl, acetyl, chlorocarbonyl, alkoxycarbonyl, in which the alkyl groups on which the alkoxy residue is based have the meaning given for R¹, aminocarbonyl, carboxylate or ammonium, sulphonium, phosphonium groups, preferably trialkyl ammonium, dialkyl sulphonium, trialkyl phosphonium, in which the alkyl residues have the meaning given for R¹; in which groups R¹ and/or R² of different monomer units can be linked directly with each other or via groups, preferably methylene, benzylidene, phenylene, in which the substitutes R¹-X and/or R² of different monomer units can be identical; in which n can take on values of 2 or higher, preferably between 3 and 200; or a mixture of poly (organylheteroacetylenes) of formula I and other polymers, in which the mass share of the added polymers can be up to 30%, are exposed to radiation of high energy density for radiation-induced modification and thus enhancement of the electrical conductance, in which temperatures of 100°C to 600°C are applied and the polymers are used freely or applied to rigid or flexible materials.

2. Structures as claimed in claim 1, characterized in that a laser beam is used for the high-density radiation.

3. Structures as claimed in claim 1, characterized in that temperatures of 150°C to 300°C are used.

4. Structures as claimed in claim 1, characterized in that metal compounds of the elements of the 8th subgroup, preferably nickel, cobalt, iron, such as their salts or complexes, preferably phosphine, phosphite and carbonyl complexes, are added, in which the share of metal compounds referred to the polymer weighed portion can be up to 5%, preferably between 0.5 and 3%.

5. Structures as claimed in claim 1, characterized in that the polymers, depending on the purpose of application, are selected so that they are sensitive to the corresponding radiation wavelength.

6. Structures as claimed in claim 1, characterized in that a coating layer is later applied or the polymers are radiated through a previously applied coating layer.

## Revendications

1. Obtention de structures conductibles aux polymères par en procédé mettant en oeuvre le poly(organylhétéroacétylène) de formule I : 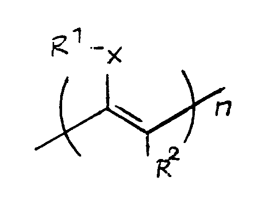 dans laquelle x symbolise le soufre ou le sélénium ; R¹ et R² symbolisent un alkyl comprenant 1 à 12 atomes de C, de préférence 1 à 7 atomes de C dont le méthyl, l'éthyl, le n-propyl, le i-propyl, le t-butyl; R¹ et R² symbolisent un cycloalkyl comprenant 3 à 10 atomes de C, de préférence 5 à 7 atomes de C dont le cyclopentyl et le cyclohexyl; R¹ et R² symbolisent un aralkyl comprenant 7 à 15 atomes de C, de préférence 7 à 11 atomes de C dont le benzyl et le phényl-éthyl; R¹ et R² symbolisent un aryle comprenant 6 à 18 atomes de C, de préférence 6 à 12 atomes de C dont le phényl et le naphtyl; R¹ et R² symbolisent un groupe hétérocyclyl comprenant 2 à 10 atomes de C et 1 à 4 hétéroatomes identiques ou différents tels l'azote, l'oxygène, le soufre, de préférence avec 4 à 7 atomes de C et 1 à 2 hétéroatomes identiques ou différents, dont par exemple l'oxygène et le soufre, le tétrahydrofuryl, le tétrahydrothiophényl, le tétrahydropyranyl, le thyényl, le furyl et le pyridyl; R² peut symboliser en outre l'hydrogène ou un groupe R3-Y, Y pouvant symboliser le soufre ou le sélénium; et Y peuvent être identiques, R³ pouvant alors revêtir la signification de R¹; R¹ et R² ou R¹ et R³ peuvent être identiques; R¹ et/ou R² ou R³ peuvent être substitués par des groupes tels les alkoxy, aralkoxy, aryloxy, hétérocycliloxy, thyoalkyl, thioaralkyl, thioaryl, thiohétérocyclyl, sélénoalkyl, sélénoaralkyl, sélénoaryl, sélénohétérocyclyl, le résidu alkyl, aralkyl, aryl ou hétérocyclyl résultant de ces groupes pouvant revêtir la signification de R¹ le cyano, les halogènes tels le fluor, le chlore, le brome ou l'iode, de préférence le chlore ou le brome, le nitro, les substituants du carbonyl comprenant 1 à 5 atomes, de préférence le formyl, l'acétyl, le carbonyl de chlore, l'alkoxycarbonyl, les groupes alkyl résultants du résidu alkoxy pouvant revêtir la signification de R¹, l'aminocarbonyl, le carboxylate ou les groupes ammonium, sulfonium et phosphonium, de préférence le trialkylammonium, le dialkylsulfonium et le trialkylphosphonium, le résidu alkyl pouvant revêtir la signification de R¹; les groupes R¹ et/ou R² d'unités monomériques différentes peuvent être reliés ensemble directement ou par l'intermédiaire de groupes, de préférence le méthylène, le benzylidène et le phénylène, les substituants R¹-X et/ou R² d'unités monomériques différentes pouvant être identiques ; n peut représenter une valeur supérieure ou égale à 2, de préférence comprise entre 3 et 200 ; ou un mélange de poly(organylhétéroacéthylène) de formule I et d'autres polymères, la masse des polymères ajoutés pouvant atteindre 30% de la masse totale, est exposé à un rayonnement de densité énergétique supérieure afin d'aboutir à une modification induite par le rayonnement et, de ce fait, à une augmentation de la conductibilité électrique, les températures s'échelonnant de 100°C à 600°C et les polymères étant utilisés en saillie ou déposés sur des matériaux rigides ou flexibles.

2. Selon la revendication I, les structures sont caractérisées par l'utilisation d'un rayonnement laser de haute densité énergétique.

3. Selon la revendication I, les structures sont caractérisées par un échelonnage des température entre 150°C et 300°C.

4. Selon la revendication I, les structures sont caractérisées par l'addition de liaisons métalliques des éléments appartenant au groupe associé 8, de préférence le nickel, le cobalt, le fer ainsi que leurs sels ou de complexes, tels les complexes de phosphine, de phosphite et de carbonyle, la proportion des liaisons métalliques pouvant être comprise de préférence entre 0,5 % et 3 % par rapport à la quantité de polymères pouvant atteindre 5 % de la masse totale.

5. Selon la revendication I, les structures sont caractérisées par la sélection des polymères en fonction de l'utilisation à laquelle on les destine, les polymères étant sensibles à la longueur d'onde correspondant au rayonnement.

6. Selon la revendication I, les structures sont caractérisées par le dépôt d'une couche de protection supplémentaire ou par une exposition des polymères à un rayonnement au moyen d'une couche de protection déposée préalablement.
